# EUROPEAN PATENT APPLICATION

(11) **EP 1 752 497 A2**
(43) Date of publication of application: **14.02.2007**
(21) Application number: 06254066.1
(22) Date of filing: 03.08.2006
(51) Int. Cl.: C09B 23/00, H01G 9/20

(54) **Organic dye compositions and use thereof in photovoltaic cells**

(30) Priority: 04.08.2005 US 197207
(71) Applicant: GENERAL ELECTRIC COMPANY, Schenectady, NY 12345 (US)
(72) Inventor: Zhang, Ruzhou, Shanghai 2000072 (CN); Xia, Zijun, Pudong, Shanghai 201203 (CN); Spivack, James Lawrence, Cobleskill, NY 12043 (US); Gui, John Yupeng, Niskayuna, New York 12309 (US); Lei, Hui, Pudong, Shanghai 201203 (CN)
(74) Representative: Szary, Anne Catherine

(57) **Abstract**

The present invention provides in one aspect a composition having at least one croconine derivative. This composition may be disposed on a semiconductor layer which is further disposed on an electrically conductive surface to provide a dye-sensitized electrode. The dye-sensitized electrode can be assembled together with a counter electrode and a redox electrolyte to provide a photovoltaic cell. The photovoltaic cell may be used as a single cell or in tandem with other cells.

## Description

### BACKGROUND

The invention includes embodiments that relate to compositions comprising croconine derivatives. The invention also includes embodiments that relate to dye-sensitized electrodes and photovoltaic cells that may be produced using compositions comprising croconine derivatives.

The dyes or sensitizers are a key feature of the dye-sensitized solar cells (DSSC) that have great potential for future photovoltaic applications owing to their potentially low production cost. The central role of the dyes is the efficient absorption of light and its conversion to electrical energy. In order for the dyes to provide high efficiency, solar radiation over as broad a spectrum as possible has to be absorbed. Further, ideally, every absorbed photon should be converted to an electron resulting from an excited dye state. In order for the dye to be returned to its initial state, ready for absorption of another photon, it has to accept an electron from the hole transport material. To ensure many turnovers and a long useful life of the device, both electron injection into the electron transport material and hole injection into the hole transport material has to be faster than any other chemistry that the dye is subject to. Furthermore, it is important that the dyes do not recapture electrons injected into the electron transport material or serve as an electronic pathway from the electron transport material to the hole transport material. Particularly desirable would be dyes with high power efficiencies for applications in DSSCs. Transition metal complexes, such as Ru(II)(2,2'-bipyridyl-4,4'dicarboxylate)₂NCS₂ have been found to be efficient sensitizers and can be attached to the semiconductor metal oxide surface through carboxyl or phosphonate groups located on the periphery of the compounds. However, these metal complexes typically have extinction coefficients for absorption (or absorptivities) on the order of 1-3x10⁴ M⁻¹ cm⁻¹. Efforts to improve dye performance in DSSCs have focused on increasing the thickness of the TiO₂ film component on which the dye is adsorbed thereby increasing the surface area available for dye adsorption. However, as a result of increasing the TiO₂ film thickness in the DSSC, the transport distance for the photo-generated electron increases, thereby increasing the possibility of unproductive back reactions. Organic dyes, such as the dyes of the rhodamine, cyanine, coumarin, or xanthene families, on the other hand, have higher extinction coefficients for absorption, on the order of 10⁵ M⁻¹ cm⁻¹. However, most organic dyes typically absorb only in a narrow range (typically less than about 100 nm) of the electromagnetic spectrum. Hence, organic dyes capable of absorbing a broad range of wavelengths in the solar spectrum as well as having strong absorptivity represent an attractive but elusive goal, since the light absorption characteristics of most organic materials cannot be predicted reliably and must be determined experimentally. Therefore, there is a need for organic dyes that absorb radiation over a broad range of the solar spectrum and have strong absorptivity. Moreover, it is very desirable to provide energy efficient photovoltaic cells that can take advantage of organic dyes that can absorb over a broad range and have high absorptivity values.

### BRIEF DESCRIPTION

In one embodiment, the present invention provides a composition comprising at least one croconine derivative having structure I 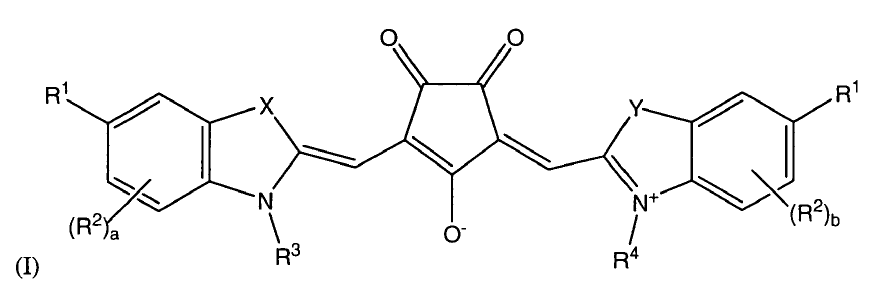 wherein R¹ and R² are independently at each occurrence a hydrogen atom , a halogen atom, a C₁-C₃₀ aliphatic radical, a C₃-C₃₀ cycloaliphatic radical, a C₃-C₃₀ aromatic radical, a hydroxyl group, a carboxy group or a salt thereof, a nitro group, a nitroso group, or a cyano group;
"a" and "b" are independently integers from 0 to 4;
R³ and R⁴ are independently at each occurrence a hydrogen atom, a C₁-C₃₀ aliphatic radical, a C₃-C₃₀ cycloaliphatic radical, a C₃-C₃₀ aromatic radical, a -(CH₂)ₙCOOA group, a -(CH₂)ₙSO₃A group, wherein n is an integer from 1 to 50, and A is a hydrogen atom, a metal cation, a peptide group, or a carbohydrate group;
X and Y are independently an oxygen atom, a sulphur atom, a selenium atom, the group N-R⁵, or the group C-R⁶R⁷wherein R⁵, R⁶, and R⁷ are independently at each occurrence a hydrogen atom, a C₁-C₃₀ aliphatic radical, a C₃-C₃₀ cycloaliphatic radical, or a C₃-C₃₀ aromatic radical;
and further wherein R¹ and an adjacent R² group may together form a cyclic structure and/or any two adjacent R² groups may together form a cyclic structure;
with the proviso that when
X and Y are both isopropylidene (C(CH₃)₂), and
"a" and "b" are both 0, and
R³ and R⁴ are both hydrogen atoms, then
R¹ is not a hydrogen atom, a butyl radical, a methoxy group, a nitro group, or an acetamido group;
and with the further proviso that structure I does not include croconine derivative having structure II

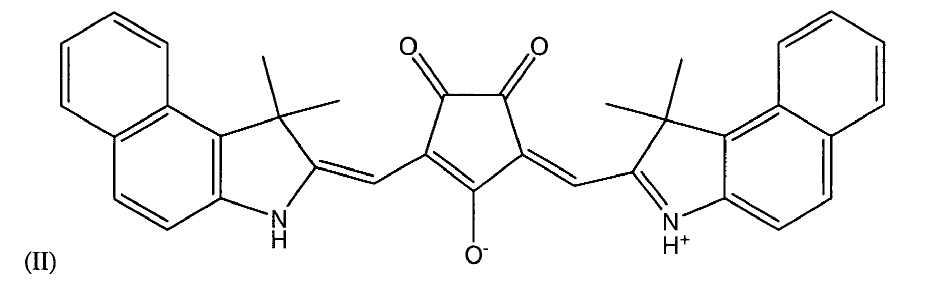

In another embodiment, the present invention provides a dye-sensitized electrode comprising a substrate having an electrically conductive surface, an electron-transporting layer that is disposed on the electrically conductive surface, and a composition comprising at least one croconine derivative having structure I disposed on the electron-transporting layer.

In yet another embodiment, the present invention provides a photovoltaic cell comprising a dye sensitized electrode, the dye sensitized electrode comprising a substrate having an electrically conductive surface, an electron transporting layer that is disposed on the electrically conductive surface, and a composition comprising at least one croconine derivative having structure I disposed on the electron transporting layer; a counter electrode; and a hole transporting layer in contact with the dye-sensitized electrode and the counter electrode.

### DETAILED DESCRIPTION

In the following specification and the claims which follow, reference will be made to a number of terms which shall be defined to have the following meanings.

The singular forms "a", "an" and "the" include plural referents unless the context clearly dictates otherwise.

As used herein, the term "aromatic radical" refers to an array of atoms having a valence of at least one comprising at least one aromatic group. The array of atoms having a valence of at least one comprising at least one aromatic group may include heteroatoms such as nitrogen, sulfur, selenium, silicon and oxygen, or may be composed exclusively of carbon and hydrogen. As used herein, the term "aromatic radical" includes but is not limited to phenyl, pyridyl, furanyl, thienyl, naphthyl, phenylene, and biphenyl radicals. As noted, the aromatic radical contains at least one aromatic group. The aromatic group is invariably a cyclic structure having 4n+2 "delocalized" electrons where "n" is an integer equal to 1 or greater, as illustrated by phenyl groups (n = 1), thienyl groups (n = 1), furanyl groups (n = 1), naphthyl groups (n = 2), azulenyl groups (n = 2), anthraceneyl groups (n = 3) and the like. The aromatic radical may also include nonaromatic components. For example, a benzyl group is an aromatic radical which comprises a phenyl ring (the aromatic group) and a methylene group (the nonaromatic component). Similarly a tetrahydronaphthyl radical is an aromatic radical comprising an aromatic group (C₆H₃) fused to a nonaromatic component ―(CH₂)₄-. For convenience, the term "aromatic radical" is defined herein to encompass a wide range of functional groups such as alkyl groups, alkenyl groups, alkynyl groups, haloalkyl groups, haloaromatic groups, conjugated dienyl groups, alcohol groups, ether groups, aldehydes groups, ketone groups, carboxylic acid groups, acyl groups (for example carboxylic acid derivatives such as esters and amides), amine groups, nitro groups, and the like. For example, the 4-methylphenyl radical is a C₇ aromatic radical comprising a methyl group, the methyl group being a functional group which is an alkyl group. Similarly, the 2-nitrophenyl group is a C₆ aromatic radical comprising a nitro group, the nitro group being a functional group. Aromatic radicals include halogenated aromatic radicals such as 4-trifluoromethylphenyl, hexafluoroisopropylidenebis(4-phen-1-yloxy) (i.e., - OPhC(CF₃)₂PhO-), 4-chloromethylphen-1-yl, 3-trifluorovinyl-2-thienyl, 3-trichloromethylphen-1-yl (i.e., 3-CCl₃Ph-), 4-(3-bromoprop-1-yl)phen-1-yl (i.e., 4-BrCH₂CH₂CH₂Ph-), and the like. Further examples of aromatic radicals include 4-allyloxyphen-1-oxy, 4-aminophen-1-yl (i.e., 4-H₂NPh-), 3-aminocarbonylphen-1-yl (i.e., NH₂COPh-), 4-benzoylphen-1-yl, dicyanomethylidenebis(4-phen-1-yloxy) (i.e., -OPhC(CN)₂PhO-), 3-methylphen-1-yl, methylenebis(4-phen-1-yloxy) (i.e., - OPhCH₂PhO-), 2-ethylphen-1-yl, phenylethenyl, 3-formyl-2-thienyl, 2-hexyl-5-furanyl, hexamethylene-1,6-bis(4-phen-1-yloxy) (i.e., ―OPh(CH₂)₆PhO-), 4-hydroxymethylphen-1-yl (i.e., 4-HOCH₂Ph-), 4-mercaptomethylphen-1-yl (i.e., 4-HSCH₂Ph-), 4-methylthiophen-1-yl (i.e., 4-CH₃SPh-), 3-methoxyphen-1-yl, 2-methoxycarbonylphen-1-yloxy (e.g., methyl salicyl), 2-nitromethylphen-1-yl (i.e., 2-NO₂CH₂Ph), 3-trimethylsilylphen-1-yl, 4-t-butyldimethylsilylphenl-1-yl, 4-vinylphen-1-yl, vinylidenebis(phenyl), and the like. The term "a C₃ ― C₁₀ aromatic radical" includes aromatic radicals containing at least three but no more than 10 carbon atoms. The aromatic radical 1-imidazolyl (C₃H₂N₂-) represents a C₃ aromatic radical. The benzyl radical (C₇H₇-) represents a C₇ aromatic radical.

As used herein the term "cycloaliphatic radical" refers to a radical having a valence of at least one, and comprising an array of atoms which is cyclic but which is not aromatic. As defined herein a "cycloaliphatic radical" does not contain an aromatic group. A "cycloaliphatic radical" may comprise one or more noncyclic components. For example, a cyclohexylmethyl group (C₆H₁₁CH₂-) is an cycloaliphatic radical which comprises a cyclohexyl ring (the array of atoms which is cyclic but which is not aromatic) and a methylene group (the noncyclic component). The cycloaliphatic radical may include heteroatoms such as nitrogen, sulfur, selenium, silicon and oxygen, or may be composed exclusively of carbon and hydrogen. For convenience, the term "cycloaliphatic radical" is defined herein to encompass a wide range of functional groups such as alkyl groups, alkenyl groups, alkynyl groups, haloalkyl groups, conjugated dienyl groups, alcohol groups, ether groups, aldehyde groups, ketone groups, carboxylic acid groups, acyl groups (for example carboxylic acid derivatives such as esters and amides), amine groups, nitro groups, and the like. For example, the 4-methylcyclopent-1-yl radical is a C₆ cycloaliphatic radical comprising a methyl group, the methyl group being a functional group which is an alkyl group. Similarly, the 2-nitrocyclobut-1-yl radical is a C₄ cycloaliphatic radical comprising a nitro group, the nitro group being a functional group. A cycloaliphatic radical may comprise one or more halogen atoms which may be the same or different. Halogen atoms include, for example; fluorine, chlorine, bromine, and iodine. Cycloaliphatic radicals comprising one or more halogen atoms include 2-trifluoromethylcyclohex-1-yl, 4-bromodifluoromethylcyclooct-1-yl, 2-chlorodifluoromethylcyclohex-1-yl, hexafluoroisopropylidene-2,2-bis (cyclohex-4-yl) (i.e., ―C₆H₁₀C(CF₃)₂ C₆H₁₀-), 2-chloromethylcyclohex-1-yl, 3- difluoromethylenecyclohex-1-yl, 4-trichloromethylcyclohex-1-yloxy, 4-bromodichloromethylcyclohex-1-ylthio, 2-bromoethylcyclopent-1-yl, 2-bromopropylcyclohex-1-yloxy (e.g., CH₃CHBrCH₂C₆H₁₀-), and the like. Further examples of cycloaliphatic radicals include 4-allyloxycyclohex-1-yl, 4-aminocyclohex-1-yl (i.e., H₂NC₆H₁₀-), 4-aminocarbonylcyclopent-1-yl (i.e., NH₂COC₅H₈-), 4-acetyloxycyclohex-1-yl, 2,2-dicyanoisopropylidenebis(cyclohex-4-yloxy) (i.e., -OC₆H₁₀C(CN)₂C₆H₁₀O-), 3-methylcyclohex-1-yl, methylenebis(cyclohex-4-yloxy) (i.e., ―OC₆H₁₀CH₂C₆H₁₀O-), 1-ethylcyclobut-1-yl, cyclopropylethenyl, 3-formyl-2-terahydrofuranyl, 2-hexyl-5-tetrahydrofuranyl, hexamethylene-1,6-bis(cyclohex-4-yloxy) (i.e., ―O C₆H₁₀(CH₂)₆C₆H₁₀O-), 4-hydroxymethylcyclohex-1-yl (i.e., 4-HOCH₂C₆H₁₀-), 4-mercaptomethylcyclohex-1-yl (i.e., 4-HSCH₂C₆H₁₀-), 4-methylthiocyclohex-1-yl (i.e., 4-CH₃SC₆H₁₀-), 4-methoxycyclohex-1-yl, 2-methoxycarbonylcyclohex-1-yloxy (2-CH₃OCOC₆H₁₀O-), 4-nitromethylcyclohex-1-yl (i.e., NO₂CH₂C₆H₁₀-), 3-trimethylsilylcyclohex-1-yl, 2-t-butyldimethylsilylcyclopent-1-yl, 4-trimethoxysilylethylcyclohex-1-yl (e.g., (CH₃O)₃SiCH₂CH₂C₆H₁₀-), 4-vinylcyclohexen-1-yl, vinylidenebis(cyclohexyl), and the like. The term "a C₃ - C₁₀ cycloaliphatic radical" includes cycloaliphatic radicals containing at least three but no more than 10 carbon atoms. The cycloaliphatic radical 2-tetrahydrofuranyl (C₄H₇O-) represents a C₄ cycloaliphatic radical. The cyclohexylmethyl radical (C₆H₁₁CH₂-) represents a C₇ cycloaliphatic radical.

As used herein the term "aliphatic radical" refers to an organic radical having a valence of at least one consisting of a linear or branched array of atoms which is not cyclic. Aliphatic radicals are defined to comprise at least one carbon atom. The array of atoms comprising the aliphatic radical may include heteroatoms such as nitrogen, sulfur, silicon, selenium and oxygen or may be composed exclusively of carbon and hydrogen. For convenience, the term "aliphatic radical" is defined herein to encompass, as part of the "linear or branched array of atoms which is not cyclic" a wide range of functional groups such as alkyl groups, alkenyl groups, alkynyl groups, haloalkyl groups , conjugated dienyl groups, alcohol groups, ether groups, aldehyde groups, ketone groups, carboxylic acid groups, acyl groups (for example carboxylic acid derivatives such as esters and amides), amine groups, nitro groups, and the like. For example, the 4-methylpent-1-yl radical is a C₆ aliphatic radical comprising a methyl group, the methyl group being a functional group which is an alkyl group. Similarly, the 4-nitrobut-1-yl group is a C₄ aliphatic radical comprising a nitro group, the nitro group being a functional group. An aliphatic radical may be a haloalkyl group which comprises one or more halogen atoms which may be the same or different. Halogen atoms include, for example; fluorine, chlorine, bromine, and iodine. Aliphatic radicals comprising one or more halogen atoms include the alkyl halides trifluoromethyl, bromodifluoromethyl, chlorodifluoromethyl, hexafluoroisopropylidene, chloromethyl, difluorovinylidene, trichloromethyl, bromodichloromethyl, bromoethyl, 2-bromotrimethylene (e.g., -CH₂CHBrCH₂-), and the like. Further examples of aliphatic radicals include allyl, aminocarbonyl (i.e.,-CONH₂), carbonyl, 2,2-dicyanoisopropylidene (i.e., -CH₂C(CN)₂CH₂-), methyl (i.e.,-CH₃), methylene (i.e., ―CH₂-), ethyl, ethylene, formyl (i.e.,-CHO), hexyl, hexamethylene, hydroxymethyl (i.e.,-CH₂OH), mercaptomethyl (i.e., ―CH₂SH), methylthio (i.e., ―SCH₃), methylthiomethyl (i.e., ―CH₂SCH₃), methoxy, methoxycarbonyl (i.e., CH₃OCO-) , nitromethyl (i.e., -CH₂NO₂), thiocarbonyl, trimethylsilyl ( i.e., (CH₃)₃Si-), t-butyldimethylsilyl, 3-trimethyoxysilypropyl (i.e., (CH₃O)₃SiCH₂CH₂CH₂-), vinyl, vinylidene, and the like. By way of further example, a C₁ ― C₁₀ aliphatic radical contains at least one but no more than 10 carbon atoms. A methyl group (i.e., CH₃-) is an example of a C₁ aliphatic radical. A decyl group (i.e., CH₃(CH2)₉-) is an example of a C₁₀ aliphatic radical.

As used herein, the term "peptide" refers to a linear sequence of amino acids connected one to the other by peptide bonds between the alpha amino and carboxyl groups of adjacent amino acids. The amino acids may be the standard amino acids or some other non standard amino acids. Some of the standard nonpolar (hydrophobic) amino acids include alanine (Ala), leucine (Leu), isoleucine (Ile), valine (Val), proline (Pro), phenylalanine (Phe), tryptophan (Trp) and methionine (Met). The polar neutral amino acids include glycine (Gly), serine (Ser), threonine (Thr), cysteine (Cys), tyrosine (Tyr), asparagine (Asn) and glutamine (Gln). The positively charged (basic) amino acids include arginine (Arg), lysine (Lys) and histidine (His). The negatively charged (acidic) amino acids include aspartic acid (Asp) and glutamic acid (Glu). The non standard amino acids may be formed in body, for example by posttranslational modification, some examples of such amino acids being selenocysteine and pyrolysine. The peptides can be of a variety of lengths, either in their neutral (uncharged) form or in forms such as their salts. The peptides can be either free of modifications such as glycosylations, side chain oxidation or phosphorylation or comprising such modifications. Substitutes for an amino acid within the sequence can also be selected from other members of the class to which the amino acid belongs. Also included in the definition are peptides modified by additional substituents attached to the amino side chains, such as glycosyl units, lipids or inorganic ions such as phosphates as well as chemical modifications of the chains. Thus, the term "peptide" or its equivalent is intended to include the appropriate amino acid sequence referenced, subject to the foregoing modifications, which do not destroy its functionality.

As used herein, the term "carbohydrate" refers to a polyhydroxy aldehyde or ketone, or a compound that can be derived from them by any of several means including (1) reduction to give sugar alcohols, (2) oxidation to give sugar acids; (3) substitution of one or more of the hydroxyl groups by various chemical groups, for example, hydrogen may be substituted to give deoxysugars, and amino group (NH₂ or acetyl-NH) may be substituted to give amino sugars; (4) derivatization of the hydroxyl groups by various moieties, for example, phosphoric acid to give phosphor sugars, or sulphuric acid to give sulfo sugars, or reaction of the hydroxyl groups with alcohols to give monosaccharides, disaccharides, oligosaccharides, and polysaccharides. In one embodiment of the present invention, carbohydrate group comprises monosaccharides, disaccharides, or oligosaccharides. Suitable monosaccharides include, but are not limited to, glucose, fructose, mannose and galactose. A disaccharide, as further defined herein, is a compound which upon hydrolysis yields two molecules of a monosaccharide. Suitable disaccharides include, but are not limited to, lactose, maltose, isomaltose, trehalose, maltulose, and sucrose. Suitable oligosaccharides include, but are not limited to, raffinose and acarbose. Also included are the saccharides modified by additional substituents, for example, methyl glycosides, N-acetyl-glucosamine, N- acetyl-galactosamine and their de-acetylated forms.

As used herein, the term "electromagnetic radiation" means electromagnetic radiation having wavelength in the range from about 200 nm to about 2500 nm.

The present invention provides a composition comprising at least one croconine derivative having structure I 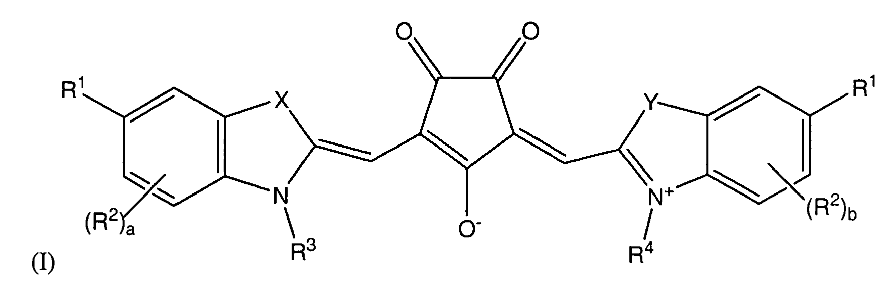 wherein R¹ and R² are independently at each occurrence a hydrogen atom , a halogen atom, a C₁-C₃₀ aliphatic radical, a C₃-C₃₀ cycloaliphatic radical, a C₃-C₃₀ aromatic radical, a hydroxyl group, a carboxy group or a salt thereof, a nitro group, a nitroso group, or a cyano group;
"a" and "b" are independently integers from 0 to 4;
R³ and R⁴ are independently at each occurrence a hydrogen atom, a C₁-C₃₀ aliphatic radical, a C₃-C₃₀ cycloaliphatic radical, a C₃-C₃₀ aromatic radical, a -(CH₂)ₙCOOA group, a -(CH₂)ₙSO₃A group, wherein n is an integer from 1 to 50 and A is a hydrogen atom, a metal cation, a peptide group, or a carbohydrate group;
X and Y are independently an oxygen atom, a sulphur atom, a selenium atom, the group N-R⁵, or the group C-R⁶R⁷wherein R⁵, R⁶, and R⁷ are independently at each occurrence a hydrogen atom, a C₁-C₃₀ aliphatic radical, a C₃-C₃₀ cycloaliphatic radical, or a C₃-C₃₀ aromatic radical;
and further wherein R¹ and an adjacent R² group may together form a cyclic structure and/or any two adjacent R² groups may together form a cyclic structure;
with the proviso that when
X and Y are both isopropylidene (C(CH₃)₂), and
"a" and "b" are both 0, and
R³ and R⁴ are both hydrogen atoms, then
R¹ is not a hydrogen atom, a butyl radical, a methoxy group, a nitro group, or an acetamido group;
and with the further proviso that structure I does not include croconine derivative having structure II

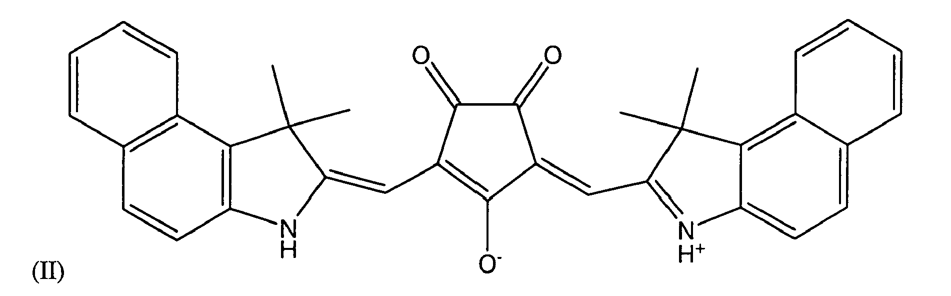

Some illustrative examples of croconine derivatives represented by structure I include, but are not limited to, structures III, IV, V, and VI. 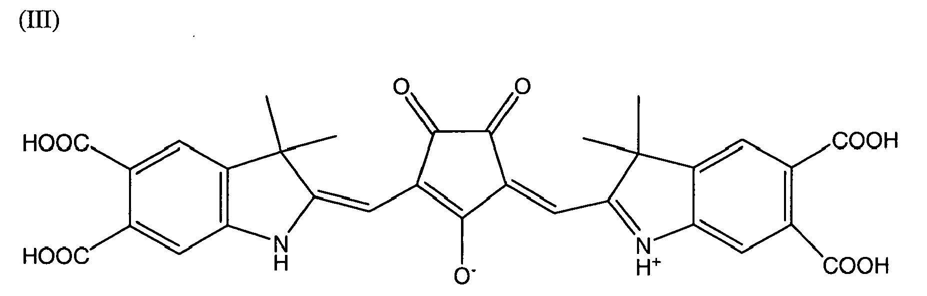 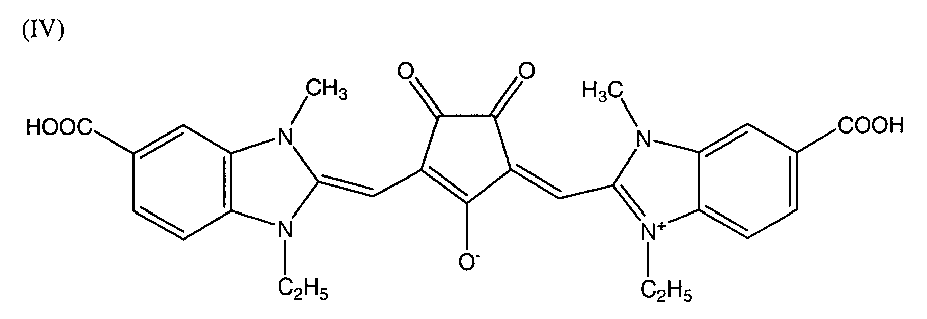 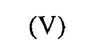 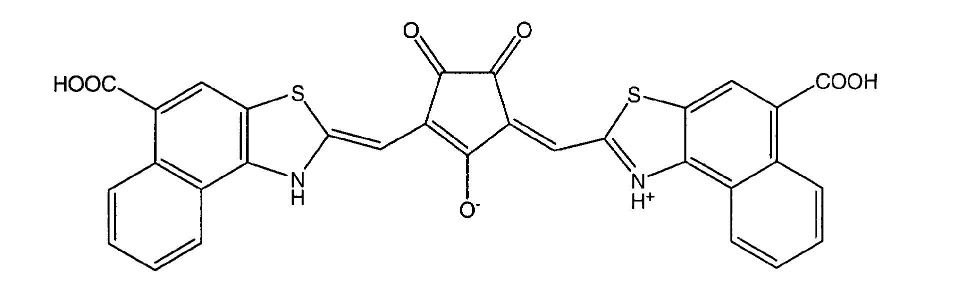 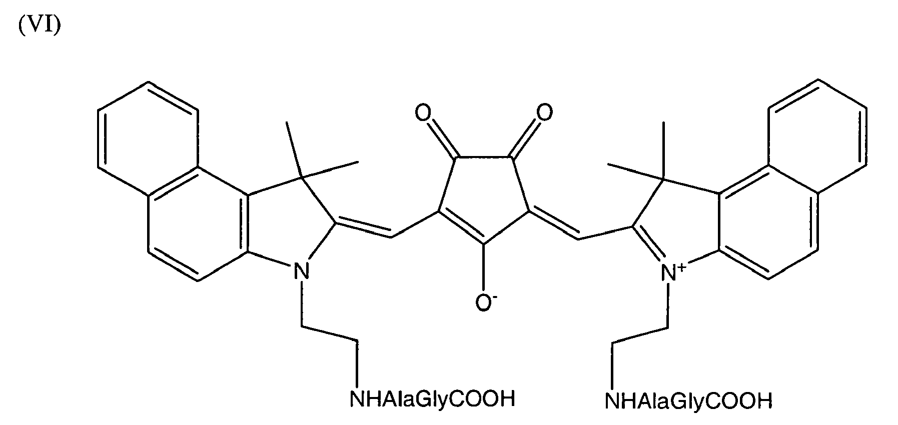 wherein "Ala" in structure VI is an alanine amino acid residue and "Gly" in structure VI is a glycine amino acid residue.

Thus, by way of example in one embodiment of the present invention, the croconine derivative has structure III. Structure III falls within generic formula I and represents the case wherein the integers "a" and "b" are equal to one, R¹ and R² are a carboxylic acid group, R³ and R⁴ are a hydrogen atom, and X and Y are an isopropylidene radical. In another embodiment of the present invention, the croconine derivative has structure V. Structure V falls within generic formula I and represents the case
wherein the integers "a" and "b" are equal to two, R¹ is a carboxylic acid group, two adjacent R² groups form a fused phenyl ring, R³ and R⁴ are a hydrogen atom, and X and Y are a sulphur atom.

In one embodiment of the present invention, the croconine derivative represented by structure I comprises at least one acidic group. The acidic groups may be comprised within R¹, R², R³ and R⁴ groups of structure I (see for example structures III, IV and V). Although not wishing to be bound by any theory, it is believed that the in dye-sensitized solar cell applications, for example, acidic groups such as carboxylic acid groups can serve to anchor the croconine dye to the surface of a semiconductor layer. It is believed that a close interaction of this type results in improvement of the adsorbing efficiency of the croconine dye. Suitable examples of acidic groups include but are not limited to carboxylic acid groups, sulfonic acid groups, phosphonic acid groups, sulfinic acid groups, boronic acid groups, their salts and mixtures thereof. In one embodiment, the preferred acidic groups for dyes used in solar cells are carboxylic acid groups and phosphonic acid groups, because they are thought to interact strongly with the surface hydroxyl groups of the semiconductor surface. It should be noted that the term acidic group encompasses both protonated and deprotonated forms of the acidic group. For example, when the acidic group is described as a "carboxylic acid group", it is to be understood that both the protonated form of the carboxylic acid (CO₂H) and deprotonated form of the carboxylic acid (CO₂⁻) are included within the meaning of the term "carboxylic acid group". The deprotonated form of the "carboxylic acid group" at times is referred to herein as a "carboxylate group" (CO₂⁻).

In one embodiment of the present invention, the croconine derivative represented by structure I comprises at least one peptide or sachharide group. In one embodiment, the peptide or sachharide groups are comprised within R³ and R⁴ groups of structure I. Thus, by way of example in one embodiment of the present invention, the croconine derivative has structure VI. Structure VI falls within generic formula I and represents the case wherein the integers "a" and "b" are equal to one, R¹ and R² are adjacent to each other and form a fused phenyl ring, X and Y are an isopropylidene radical, and R³ and R⁴ are a CH₂CH₂NHAlaGlyCOOH group, where "Ala" and "Gly" form a peptide linkage. Although not wishing to be bound by any theory, it is believed that in biosensor applications, for example, biocompatible groups such as peptide or sachharide groups may serve to make the croconine dye more biocompatible.

In another embodiment of the present invention, the croconine derivative has structure VII 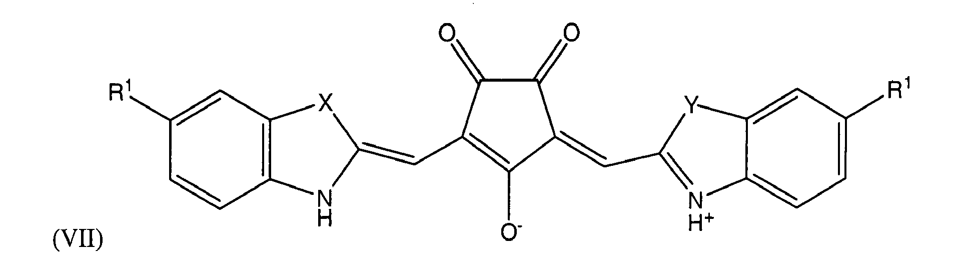 wherein R¹ is a hydrogen atom, a halogen atom, a C₁-C₃₀ aliphatic radical, a C₃-C₃₀ cycloaliphatic radical, a C₃-C₃₀ aromatic radical, a hydroxyl group, a carboxy group or a salt thereof, a nitro group, a nitroso group, or a cyano group; and X and Y are independently an oxygen atom, a sulphur atom, a selenium atom, the group N-R⁵, or the group C-R⁶R⁷wherein R⁵, R⁶, and R⁷ are independently at each occurrence a hydrogen atom, a C₁-C₃₀ aliphatic radical, a C₃-C₃₀ cycloaliphatic radical, or a C₃-C₃₀ aromatic radical; with the proviso that when X and Y are both isopropylidene (C(CH₃)₂), R¹ is not a hydrogen atom, a butyl radical, a methoxy radical, a nitro group, or an acetamido group.

Some illustrative examples of croconine derivatives represented by structure VII include, but are not limited to, structures VIII, IX, and X. 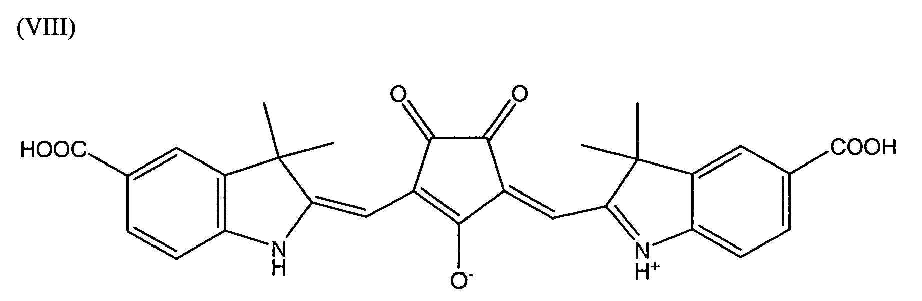 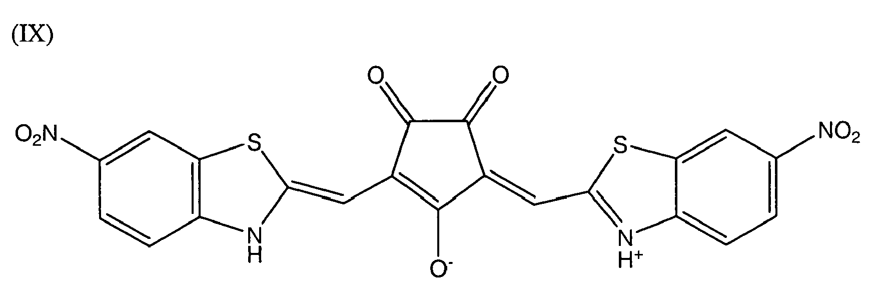 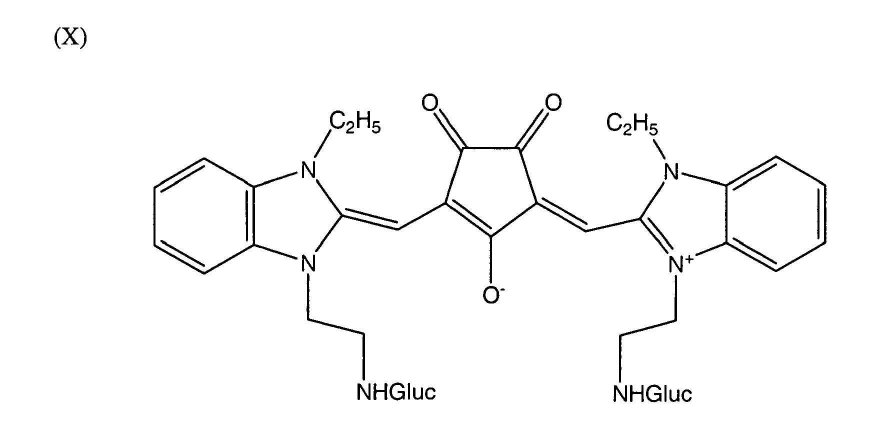 wherein "Gluc" in structure X is a glucose residue.

In another embodiment of the present invention the croconine derivative has structure XI. 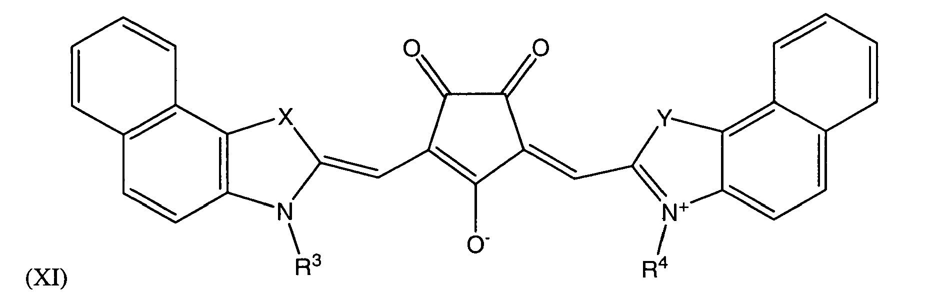 wherein R³ and R⁴ are independently at each occurrence a hydrogen atom, a C₁-C₃₀ aliphatic radical, a C₃-C₃₀ cycloaliphatic radical, a C₃-C₃₀ aromatic radical, a - (CH₂)ₙCOOA group, a -(CH₂)ₙSO₃A group, wherein n is an integer from 1 to 50 and A is a hydrogen atom, a metal cation, a peptide group, or a carbohydrate group; and X and Y are independently an oxygen atom, a sulphur atom, a selenium atom, the group N-R⁵, or the group C-R⁶R⁷wherein R⁵, R⁶, and R⁷ are independently at each occurrence a hydrogen atom, a C₁-C₃₀ aliphatic radical, a C₃-C₃₀ cycloaliphatic radical, or a C₃-C₃₀ aromatic radical; with the proviso that when X and Y are both isopropylidene (C(CH₃)₂), R³ and R⁴ are not hydrogen atoms.

Some illustrative examples of croconine derivatives represented by structure XI include, but are not limited to, structures XII, XIII, and XIV.

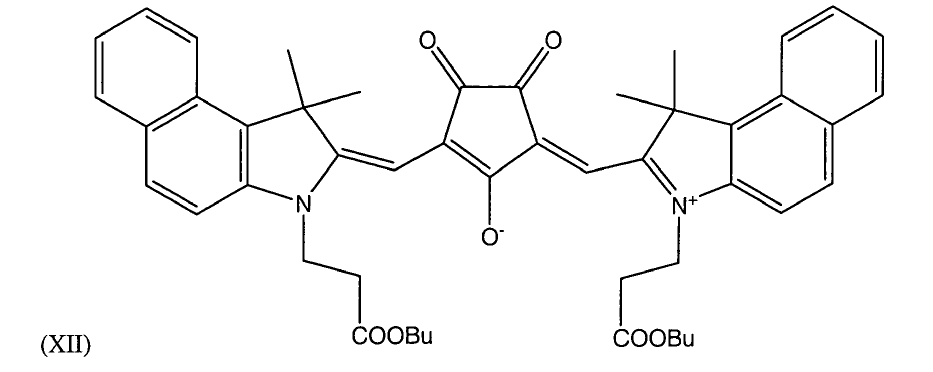

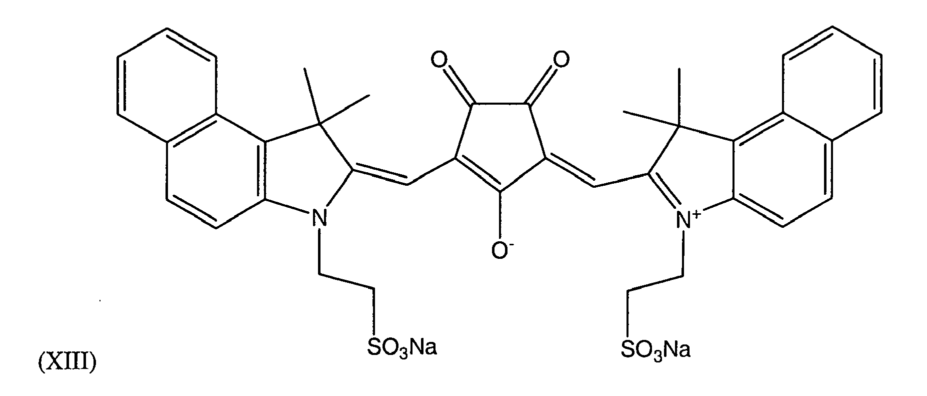

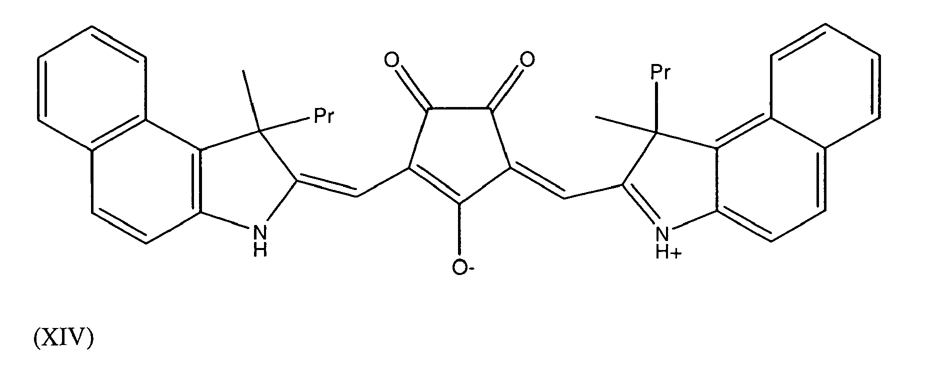

In one embodiment of the present invention, the croconine derivative has structure I. 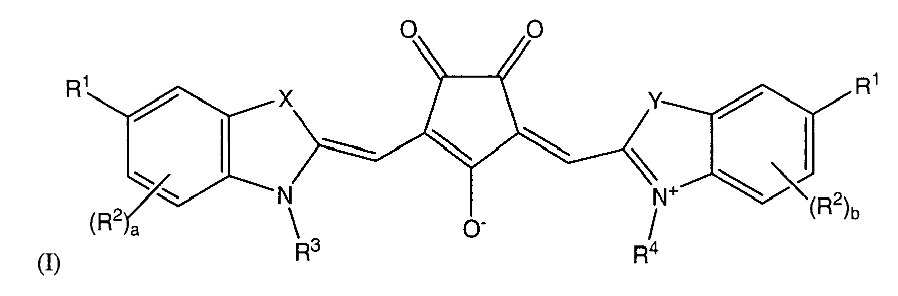 wherein R¹ and R² are independently at each occurrence a hydrogen atom , a halogen atom, a C₁-C₃₀ aliphatic radical, a C₃-C₃₀ cycloaliphatic radical, a C₃-C₃₀ aromatic radical, a hydroxyl group, a carboxy group or a salt thereof, a nitro group, a nitroso group, or a cyano group;
"a" and "b" are independently integers from 0 to 4;
R³ and R⁴ are independently at each occurrence a hydrogen atom, a C₁-C₃₀ aliphatic radical, a C₃-C₃₀ cycloaliphatic radical, a C₃-C₃₀ aromatic radical, a -(CH₂)ₙCOOA group, a -(CH₂)ₙSO₃A group, wherein n is an integer from 1 to 50 and A is a hydrogen atom, a metal cation, a peptide group, or a carbohydrate group;
X and Y are independently an oxygen atom, a sulphur atom, a selenium atom, the group N-R⁵, or the group C-R⁶R⁷wherein R⁵, R⁶, and R⁷ are independently at each occurrence a hydrogen atom, a C₁-C₃₀ aliphatic radical, a C₃-C₃₀ cycloaliphatic radical, or a C₃-C₃₀ aromatic radical;
and further wherein R¹ and an adjacent R² group may together form a cyclic structure and/or any two adjacent R² groups may together form a cyclic structure;
with the proviso that when
X and Y are both isopropylidene (C(CH₃)₂), and
"a" and "b" are both 0, and
R³ and R⁴ are both hydrogen atoms, then
R¹ is not a hydrogen atom, a C₁-C₅ alkyl radical, a C₁-C₅ alkoxy radical, a nitro group, or an acetamido group;
and with the further proviso that structure I does not include croconine derivative having structure II.

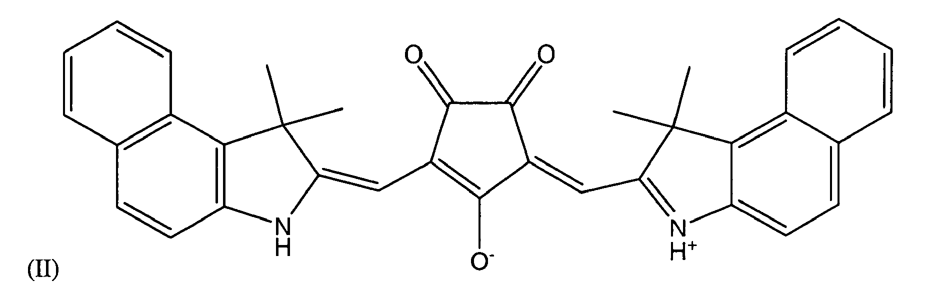

The croconine compositions of the present invention may be prepared by reacting croconic acid with a suitable indolenine derivative. Thus, in one aspect, the present invention provides a method for the preparation of novel croconine derivatives. Croconic acid and the indolenine may be prepared by methods known to those skilled in the art. In one embodiment, for example, the indolenine derivative is prepared from a substituted phenylhydrazine and an isopropylmethylketone via the Fischer Indole synthesis reaction. Once in hand, this substituted indolenine may be reacted with half an equivalent of croconic acid to produce the croconine derivative. The reaction product comprising the croconine derivative may be purified by conventional techniques such as crystallization, trituration, and/or chromatography.

The compositions of the present invention are useful as photosensitizers for applications in optoelectronic devices, optical sensors, devices for hydrogen preparation by water splitting, biosensors, and as absorptive contrast agents. In one embodiment, the compositions of the present invention are comprised within the dye component of a dye-sensitized electrode. In a further embodiment, the compositions of the present invention are comprised within the dye component of a dye-sensitized electrode present in a dye-sensitized solar cell.

Thus, in one embodiment, the present invention provides a dye-sensitized electrode comprising a substrate having an electrically conductive surface, an electron transporting layer that is disposed on the electrically conductive surface, and a composition comprising at least one croconine derivative disposed on the electron transporting layer. In one embodiment of the present invention, the croconine derivative has structure I. In another embodiment of the present invention, the croconine derivative has structure VII. In yet another embodiment of the present invention, the croconine derivative has structure XI.

In one embodiment, the substrate of the dye-sensitized electrode comprises at least one glass film. In an alternate embodiment the substrate comprises at least one polymeric material. Examples of suitable polymeric materials include but are not limited to polyacrylates, polycarbonates, polyesters, polysulfones, polyetherimides, silicones, epoxy resins, and silicone-functionalized epoxy resins. The substrate is selected so that it is substantially transparent, that is, a test sample of the substrate material having a thickness of about 0.5 micrometer allows approximately 80 percent of incident electromagnetic radiation having wavelength in the range from about 290 nm to about 1200 nm at an incident angle less than about 10 degrees to be transmitted through the sample.

At least one surface of the substrate is coated with a substantially transparent, electrically conductive material. Suitable materials that can be used for coating are substantially transparent conductive oxides, such as indium tin oxide (ITO), tin oxide, indium oxide, zinc oxide, antimony oxide, and mixtures thereof. A substantially transparent layer, a thin film, or a mesh structure of metal such as silver, gold, platinum, titanium, aluminum, copper, steel, or nickel may be also suitable.

The dye-sensitized electrode further comprises an electron-transporting layer disposed in electrical contact with the electrically conductive material coated on the substrate. The electron-transporting layer facilitates transfer of charge across the cell by transferring the electron ejected from the croconine derivative to the electrode. It is thus desirable for the electron transporting layer to have a lowest unoccupied molecular orbital (LUMO) energy level or conduction band edge that closely matches the LUMO of the croconine derivative to facilitate the transport of electrons between the croconine derivative and said electron transporting layer.

Examples of suitable materials for electron transporting layer include, but is are not limited to, metal oxide semiconductors; tris-8-hydroxyquinolato aluminum (AlQ3); cyano-polyphenylene vinylene (CN-PPV); and oligomers or polymers comprising electron deficient heterocyclic moieties, such as 2,5-diaryloxadiazoles, diaryl trazoles, triazines, pyridines, quinolines, benzoxazoles, benzthiazoles, or the like. Other exemplary electron transporters are particularly functionalized fullerenes (e.g., 6,6-phenyl-C61-butyl acid-methylester), difluorovinyl-(hetero)arylenes, 3-(1,1-difluoroalkyl)thiophene group, pentacene, poly(3-hexylthiophene), α,ω-substituted sexithiophenes, n-decapentafluoroheptyl-methylnaphthalene -1,4,5,8-tetracarboxylic diimide, dihexyl-quinquethiophene, poly(3-hexylthiophene), poly(3-alkylthiophene), di-hexyl-hexathiophene, dihexyl-anthradithiophene, phthalocyanine, C60 fullerene, or the like, or a combination comprising at least one of the foregoing electron transporters.

In one embodiment, a metal-oxide semiconductor is used as an electron-transporting layer. Suitable metal oxide semiconductors are oxides of the transition metals and oxides of the elements of Group III, IV, V, and VI of the Periodic Table. Oxides of titanium, zirconium, hafnium, strontium, zinc, indium, yttrium, lanthanum, vanadium, niobium, tantalum, chromium, molybdenum, tungsten, iron, nickel, silver or mixed oxides of these metals may be employed. Other suitable oxides include those having a perovskite structure such as SrTiO₃ or CaTiO₃. The semiconductor layer is coated by adsorption of the composition comprising the croconine derivative on the surface thereof. As noted, the croconine derivative is thought to interact strongly with the surface of the semiconductor layer via the acidic groups present in the composition. In another embodiment titanium dioxide (TiO₂) is used as an electron-transporting layer.

In one embodiment, the present invention provides a photovoltaic cell comprising a dye sensitized electrode comprising a substrate having an electrically conductive surface, an electron transporting layer that is disposed on the electrically conductive surface, and a composition comprising at least one croconine derivative disposed on the electron transporting layer; a counter electrode; and a hole transporting layer in contact with the dye-sensitized electrode and the counter electrode.

Any electrically conductive material may be used as the counter electrode. Illustrative examples of suitable counter electrodes are a platinum electrode, a rhodium electrode, a ruthenium electrode or a carbon electrode.

The hole-transporting layer facilitates transfer of charge across the cell by transferring the holes from the croconine derivative to the electrode. Thus, it is also desirable for the hole-transporting layer to have a highest occupied molecular orbital (HOMO) energy level that closely matches the HOMO of the croconine derivative to facilitate the transport of holes between the croconine derivative and the hole-transporting layer.

Examples of suitable materials for hole transporting layer includes, but are not limited to, hydrazone compounds, styryl compounds, diamine compounds, aromatic tertiary amine compounds, butadiene compounds, indole compounds, carbazole derivatives, triazole derivatives, imidazole derivatives, oxadiazole derivatives having an amino group, or the like, or a combination comprising at least one of the foregoing materials. Yet other examples of suitable hole transporters are triphenylmethane, bis(4-diethylamine-2-methylphenyl) phenylmethane, stylbene, hydrozone; aromatic amines comprising tritolylamine; arylamine; enamine phenanthrene diamine; N,N'-bis-(3,4-dimethylphenyl)-4-biphenyl amine; N,N'-bis-(4-methylphenyl)-N,N'-bis(4-ethylphenyl)-1,1'-3,3'-dimethylbiphenyl)-4,4'-diamine; 4-4'-bis(diethylamino)-2,2'-dimethyltriphenylmethane; N,N'-diphenyl-N,N'-bis(3-methylphenyl)-[1,1'-biphenyl]-4,4'-diamine; N,N'-diphenyl-N,N'-bis(4-methylphenyl)-1,1'- biphenyl-4,4'-diamine; N,N'-diphenyl-N,N'-bis(alkylphenyl)-1,1'-biphenyl-4,4'-diamine; and N,N'-diphenyl-N,N'-bis(chlorophenyl)-1,1'-biphenyl-4,4'-diamine; 1,1-bis(4-di-p-tolylaminophenyl)cyclohexane; 1,1-bis(4-di-p-tolylaminophenyl)-4-phenylcyclohexane; 4,4'-bis(diphenylamino)quadriphenyl; bis(4-dimethylamino-2-methylphenyl)-phenylmethane; N,N,N-Tri(p-tolyl)amine; 4-(di-p-tolylamino)-4'-[4(di-p-tolylamino)-styryl] stilbene; N,N,N',N'-tetra-p-tolyl-4-4'-diaminobiphenyl; N,N,N',N'-tetraphenyl-4,4'-diaminobiphenyl; N,N,N',N'-tetra-1-naphthyl-4,4'-diaminobiphenyl; N,N,N',N'-tetra-2-naphthyl-4,4'-diaminobiphenyl; N-phenylcarbazole; 4,4'-bis[N-(1-naphthyl)-N-phenylamino]biphenyl; 4,4'-bis[N-(1-naphthyl)-N-(2-naphthyl)amino]biphenyl; 4,4''-bis[N-(1-naphthyl)-N-phenylamino]p-terphenyl; 4,4'-bis[N-(2-naphthyl)-N-phenylamino]biphenyl; 4,4'-bis[N-(3-acenaphthenyl)-N-phenylamino]biphenyl; 1,5-bis[N-(1-naphthyl)-N-phenylamino]naphthalene; 4,4'-bis[N-(9-anthryl)-N-phenylamino]biphenyl; 4,4"-bis[N-(1-anthryl)-N-phenylamino]-p-terphenyl; 4,4'-bis[N-(2-phenanthryl)-N-phenylamino]biphenyl; 4,4'-bis[N-(8-fluoranthenyl)-N-phenylamino]biphenyl; 4,4'-bis[N-(2-pyrenyl)-N-phenylamino]biphenyl; 4,4'-bis[N-(2-naphthacenyl)-N-phenylamino]biphenyl; 4,4'-bis[N-(2-perylenyl)-N-phenylamino]biphenyl; 4,4'-bis[N-(1-coronenyl)-N-phenylamino]biphenyl; 2,6-bis(di-p-tolylamino)naphthalene; 2,6-bis[di-(1-naphthyl)amino]naphthalene; 2,6-bis[N-(1-naphthyl)-N-(2-naphthyl)amino]naphthalene; N,N,N',N'-tetra(2-naphthyl)-4,4"-diamino-p-terphenyl; 4,4'-bis {N-phenyl-N-[4-(1-naphthyl)-phenyl]amino} biphenyl; 4,4'-bis[N-phenyl-N-(2-pyrenyl)amino]biphenyl; 2,6-bis[N,N-di(2-naphthyl)amine]fluorine; 1,5-bis[N-(1-naphthyl)-N-phenylamino]naphthalene; or the like, or a combination comprising at least one of the foregoing hole transporters.

The hole-transporting layer may also comprise intrinsically conducting polymers. Examples of suitable intrinsically conducting polymers are poly(acetylene) and its derivatives; poly(thiophenes) and its derivatives; poly(3,4-ethylenedioxythiophene) and poly(3,4-ethylenedithiathiophene) and their derivatives; poly(isathianaphthene), poly(pyridothiophene), poly(pyrizinothiophene), and their derivatives; poly(pyrrole) and its derivatives; poly(3,4-ethylenedioxypyrrole) and its derivatives; poly(aniline) and its derivatives; poly(phenylenevinylene) and its derivatives; poly(p-phenylene) and its derivatives; poly(thionapthene), poly(benzofuran), and poly(indole) and their derivatives; poly(dibenzothiophene), poly(dibenzofuran), poly(carbazole) and their derivatives; poly(bithiophene), poly(bifuran), poly(bipyrrole), and their derivatives; poly(thienothiophene), poly(thienofuran), poly(thienopyrrole), poly(furanylpyrrole), poly(furanylfuran), poly(pyrolylpyrrole), and their derivatives; poly(terthiophene), poly(terfuran), poly(terpyrrole), and their derivatives; poly(dithienothiophene), poly(difuranylthiophene), poly(dipyrrolylthiophene), poly(dithienofuran), poly(dipyrrolylfuran), poly(dipyrrolylpyrrole) and their derivatives; poly(phenyl acetylene) and its derivatives; poly(biindole) and derivatives; poly(dithienovinylene), poly(difuranylvinylene), poly(dipyrrolylvinylene) and their derivatives; poly(1,2-trans(3,4-ethylenedioxythienyl)vinylene), poly(1,2-trans(3,4-ethylenedioxyfuranyl)vinylene), poly(1,2-trans(3,4-ethylenedioxypyrrolyl)vinylene), and their derivatives; poly(bis-thienylarylenes) and poly(bis-pyrrolylarylenes) and their derivatives; poly(dithienylcyclopentenone); poly(quinoline); poly(thiazole); poly(fluorene); poly(azulene); or the like, or a combination comprising at least one of the foregoing intrinsically conducting polymers.

The hole-transporting layer may be liquid or solid. In the case of a liquid hole transporting layer an ionic liquid or an electrolyte may be used. Suitable examples of ionic liquids that may used as the hole transporter are methylpropylimidazolium triaflate, methylpropylimidazolium bistriflimide, methylpropylimidazolium nanoaflate, methylpropylimidazolium ethersulfonate, methylpropylimidazolium iodide, methylpropylimidazolium triiodide, methylpropylimidazolium halides, metal complex cations with phosphonium anion, or the like, or a combination comprising at least one of the foregoing hole transporters.

In one embodiment a redox electrolyte is used as a hole-transporting layer. The redox electrolyte can be, for example, a I⁻/I₃⁻ system, a Br⁻/Br₃⁻ system, or a quinone/hydroquinone system. The electrolyte can be liquid or solid. The solid electrolyte can be obtained by dispersing the electrolyte in a polymeric material. In the case of a liquid electrolyte, an electrochemical inert solvent such as acetonitrile, propylene carbonate or ethylene carbonate may be used.

The dye-sensitized electrode, the counter electrode and the hole-transporting layer may be arranged in a case or encapsulated within a resin in a way such that the dye-sensitized electrode is capable of being irradiated with electromagnetic radiation. When the dye-sensitized electrode is irradiated, an electric current is generated as a result of the electrical potential difference created during irradiation.

The photovoltaic cells of the present invention may work as a photovoltaic power source as a single cell or in tandem with other photovoltaic cells. In one embodiment of the present invention, a single photovoltaic cell is used as a photovoltaic source. In another embodiment of the present invention, pluralities of photovoltaic cells are arranged in tandem to work as a photovoltaic source. The photovoltaic cells may be arranged in series or in parallel.

In one embodiment, the present invention provides a device comprising a plurality of photovoltaic cells wherein at least one photovoltaic cell among the plurality of photovoltaic cells, comprises a composition comprising a croconine derivative. Other photovoltaic cells among the plurality may comprise other photoactive dyes such as metal complexes, azo dyes, cyanine dyes, merocyanine dyes, triphenylmethane dyes, phthalocyannine dyes, polymethine dyes, perylene dyes, porphyrin dyes, indigo dyes, naphthalocyanine dyes, quinone dyes, quinoneimine dyes, quinacridone dyes and xanthene dyes. In another embodiment of the present invention, each of the photoactive dyes of the plurality of photovoltaic cells absorbs a different portion of the electromagnetic spectrum, and all of the photoactive dyes of the plurality of photovoltaic cells together absorb substantially the whole spectrum of the electromagnetic radiation.

Without further elaboration, it is believed that one skilled in the art can, using the description herein, utilize the present invention to its fullest extent. The following examples are included to provide additional guidance to those skilled in the art in practicing the claimed invention. The examples provided are merely representative of the work that contributes to the teaching of the present application. Accordingly, these examples are not intended to limit the invention, as defined in the appended claims, in any manner.

### EXAMPLES

In the following examples reaction products were analyzed using ¹H NMR Spectroscopy, ¹³C NMR Spectroscopy, FTIR and ESI-MS.

### EXAMPLE 1 Synthesis Of Croconic Acid

To a solution of sodium rhodizonate (5 g) in water (250 mL) were added potassium carbonate (21 g) and manganese dioxide (14 g). The mixture was refluxed under stirring for 1hour (h) and then filtered at once. The resulted filtrate was acidified with aqueous HCl to pH=6-7, followed by addition of the solution of barium chloride (BaCl₂) in water. The precipitates were collected and dried in vacuum to provide golden-colored barium croconate (7.42 g).

Excess barium croconate was added to a solution of sulfuric acid (3N), and the mixture was warmed for approximately 1h. Excess barium croconate was filtered and the yellow filtrate was concentrated at 40°C under reduced pressure, to give crude croconic acid, which was purified by recrystallization in water to give pure croconic acid as needles or plates. ¹³C NMR (D₂O) δ: 191.7, 181.2, 160.6, 149.0.

### EXAMPLE 2 Synthesis Of 2,3,3-Trimethyl-5-Carboxyl-Indolenine

4-Carboxyphenylhydrazine (0.1 mol) and isopropylmethyl ketone (8.6 g, 10.7 mL, 0.1mol) were heated together at 70°C for 4h. After cooling to room temperature, 60% H₂SO₄ (11 mL, 0.1 mol) was added and the mix was heated at 90°C for 3h, followed by neutralization at room temperature with sodium bicarbonate. The organic layer was extracted with ethyl ether and dried over sodium sulfate (Na₂SO₄). After removal of the solvent, the residue was purified by flash chromatography on silica gel to give 2,3,3-trimethyl-5-carboxyl-indolenine in 59% yield. ¹H NMR(400MHz, CDCl₃): δ8.16 (d, J =8.19Hz, 1H), 8.07 (s, 1H), 7.65 (d, J = 8.18Hz, 1H), 2.38 (s, 3H), 1.38 (s, 6H).

### EXAMPLE 3 Synthesis Of Croconine Derivative Having Structure VIII

2,3,3-Trimethyl-5-carboxyl-indolenine synthesized in Example 2 (4 mmol) and croconic acid synthesized in Example 1 (290 mg, 2 mmol) were dissolved in a mixed solvent *n*butanol/toluene (20mL, 1:1v/v) and heated at 110°C; water was removed azeotropically using a Dean-Stark trap. The reaction was monitored by TLC. Upon completion of the reaction, the crude product was obtained by evaporation of the resulting solution. The crude product croconine derivative was purified by flash chromatography on silica gel, followed by recrystallization from methanol to give croconine derivative VIII: Yield 67%. ¹H NMR (400MHz, *d*-DMSO) δ: 8.12 (s, 2H), 7.99 (d, J=8.09Hz, 2H), 7.65-7.55(m, 2H), 6.06(s, 2H), 1.54(s, 12H); FTIR(KBr, cm⁻¹): 1713(s), 1682(m), 1626(w), 1534(s), 1495(s), 1343(s), 1313(s), 1182(s), 961(m).

### EXAMPLE 4 Synthesis Of 1-Carboxylethyl-2,3,3-Trimethyl-4,5-Benzoindoleninium Bromide.

2,3,3-Trimethyl-4, 5-benzoindolenine (5.81 g, 27.8 mmol) and 3-bromopropionic acid (4.23 g, 27.7 mmol) were dissolved in 1,2-dichlorobenzene (80 mL). The mixture was stirred at 100°C for 20h to afford needle like crystals. The product was collected by filtration and the solid was washed with ether and dried *in vacuum* to yield 1-carboxylethyl-2,3,3-trimethyl-4,5-benzoindoleninium bromide (9.0 g, 90%). ¹H NMR (DMSO, 400 MHz): δ 8.38 (d, J=8.3Hz, 1H), 8.29 (d, J=8.9Hz, 1H), 8.22(d, J=8.0Hz, 1H), 8.18(d, J=8.9Hz, 1H), 7.79(t, J=7.0Hz, 1H), 7.73(t, J=7.0Hz, 1H), 4.78 (t, J= 6.9Hz, 2H), 3.05(t, J=6.9Hz, 2H), 2.97(s, 3H), 1.76(s, 6H); FTIR(KBr, cm⁻¹) 1591(m), 1513(m), 1478(m), 1426(s), 1360(m), 1313(w), 1139(m), 1095(s), 1008(m), 930(m), 665(m).

### EXAMPLE 5 Synthesis Of Croconine Derivative Having Structure XII

1-carboxylethyl-2,3,3-trimethyl-4,5-benzoindoleninium bromide prepared in Example 4 (4 mmol), croconic acid prepared in Example 1 (290 mg, 2 mmol) and pyridine (2 mmol) were dissolved in a mixed solvent n-butanol/toluene (20 mL, 1:1 v/v). The resulting mixture was heated at 110°C and the water produced was removed azeotropically using a Dean-Stark trap. The reaction was monitored by TLC. After completion of the reaction, the crude product was obtained by evaporation of the resulting solution. The crude product croconine derivative was esterified with butanol and purified by flash chromatography on silica gel, followed by recrystallization from methanol to give croconine derivative XII. ¹H NMR (400MHz, CDCl₃): δ 8.11 (d, J=8.3Hz, 2H), 7.97-7.90(m, 4H), 7.61(t, J=7.3Hz, 2H), 7.54-7.44(m, 4H), 6.40(s, 2H), 4.68(t, J=6.8Hz, 4H), 3.97(t, J=6.7Hz, 4H), 2.80(t, J=6.8Hz, 4H), 1.90(s, 12H), 1.53-1.42(m, 4H), 1.34-1.18(m, 4H), 0.82(t, J=7.3Hz, 6H); FTIR(KBr, cm⁻¹): 1739(m), 1565(m), 1495(s), 1452(s), 1334(s), 1313(m), 1265(m), 1026(m), 952(m); ESI-MS: 781.335 for C₄₉H₅₂N₂O₇ (100%); Calc. for C₄₉H₅₂N₂O₇ 780.910.

### EXAMPLE 6 Measurement Of UV Characteristics Of Croconine Derivatives VIII and XII Relative to The Known Dye, "N3" (Comparative Example 1).

The croconine dyes of the present invention as exemplified by croconine derivatives VIII and XII, were evaluated for suitability for use in dye-sensitized solar cells. The light absorption characteristics of croconine derivatives VIII and XII were compared with Comparative Example 1, a known dyes species, "N3" ("N3" = (Ru(bpy(COOH)₂)₂(NCS)₂), available from Solaronix). UV-visible spectra of each of VIII, XII, and "N3" were measured with SHIMADZU UV-3150 UV-Vis-NIR spectrophotometer. Data are gathered in Table 1 and show that the absorption maxima of the croconine derivatives of the present invention were observed around 790 nm. Their molar absorption coefficients were of the order of 10⁴ and were almost 5 times greater than that observed for the known dye "N3".

**Table 1 UV Characteristic Measurements Of Example 6**

| Dye | ε | A | b (cm) | solvent | Con. | λₘₐₓ(nm) |
|---|---|---|---|---|---|---|
| Croconine VIII | 6.81E+04 | 0.141 | 0.1 | DMSO | 2.07E-05 | 793 |
| Croconine XII | 5.93E+04 | 0.228 | 0.1 | CH₃OH | 3.84E-05 | 793 |
| CEx. 1 | 1.28E+04 | 0.128 | 0.1 | CHCl₃ | 9.98E-05 | 539 |

### EXAMPLE 7 Photovoltaic Cell Performance Of Croconine Derivative VIII

Croconine derivative VIII was tested in a dye-sensitized solar cell. Thus a nano-crystalline TiO₂ layer at 50°C was treated with a small volume (25-50uL) of concentrated solution of VIII in a DMSO/DMF mixture (approximately 2 mM in mixed DMSO/DMF (about 12v% DMSO)). After 15-20 minutes of treatment, the TiO₂ layer was rinsed with DMF and ethanol. Dye-sensitized solar cells were made with 10 micron TiO₂ films using standard techniques. Conventional electrolyte solutions (0.5M Pr4NI, 0.1M LiI, 0.45M tBuPyr, 0.05 M I₂) were used to assemble the test cells which were then tested under 1 sun illumination.

**Table 2 Cell Performance Measurements Of Example 7**

| TiO₂ uM | Dye | Voc volts | Jsc mA/cm² | FF | Eff % |
|---|---|---|---|---|---|
| 10uM | VIII | 0.154 | 0.12 | 0.35 | 0.01 |

Cell performance measurements showed that croconine derivative VIII produced an acceptable level of photovoltage under 1 sun (AM1.5) illumination.

## Claims

1. A composition comprising at least one croconine derivative having structure I; 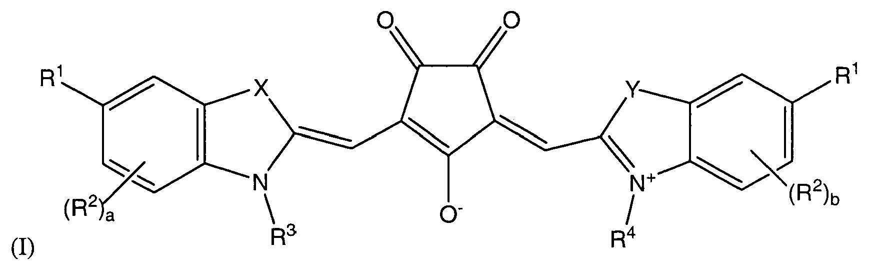 wherein R¹ and R² are independently at each occurrence a hydrogen atom , a halogen atom, a C₁-C₃₀ aliphatic radical, a C₃-C₃₀ cycloaliphatic radical, a C₃-C₃₀ aromatic radical, a hydroxyl group, a carboxy group or a salt thereof, a nitro group, a nitroso group, or a cyano group;
"a" and "b" are independently integers from 0 to 4;
R³ and R⁴ are independently at each occurrence a hydrogen atom, a C₁-C₃₀ aliphatic radical, a C₃-C₃₀ cycloaliphatic radical, a C₃-C₃₀ aromatic radical, a -(CH₂)ₙCOOA group, a -(CH₂)ₙSO₃A group, wherein n is an integer from 1 to 50 and A is a hydrogen atom, a metal cation, a peptide group, or a carbohydrate group;
X and Y are independently an oxygen atom, a sulphur atom, a selenium atom, the group N-R⁵, or the group C-R⁶R⁷wherein R⁵, R⁶, and R⁷ are independently at each occurrence a hydrogen atom, a C₁-C₃₀ aliphatic radical, a C₃-C₃₀ cycloaliphatic radical, or a C₃-C₃₀ aromatic radical;
and further wherein R¹ and an adjacent R² group may together form a cyclic structure and/or any two adjacent R² groups may together form a cyclic structure;
with the proviso that when
X and Y are both isopropylidene (C(CH₃)₂), and
"a" and "b" are both 0, and
R³ and R⁴ are both hydrogen atoms, then
R¹ is not a hydrogen atom, a butyl radical, a methoxy group, a nitro group, or an acetamido group;
and with the further proviso that structure I does not include croconine derivative having structure II

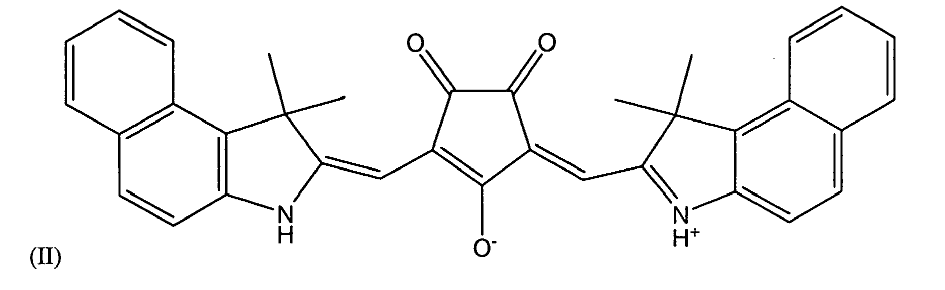

2. A composition according to claim 1, wherein the croconine derivative has structure VII; 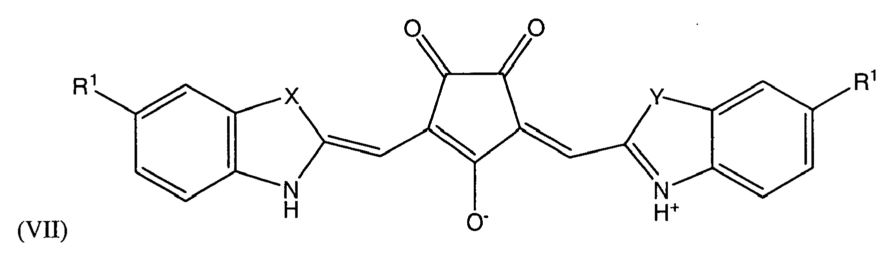 wherein R¹ is a hydrogen atom, a halogen atom, a C₁-C₃₀ aliphatic radical, a C₃-C₃₀ cycloaliphatic radical, a C₃-C₃₀ aromatic radical, a hydroxyl group, a carboxy group or a salt thereof, a nitro group, a nitroso group, or a cyano group; and X and Y are independently an oxygen atom, a sulphur atom, a selenium atom, the group N-R⁵, or the group C-R⁶R⁷wherein R⁵, R⁶, and R⁷ are independently at each occurrence a hydrogen atom, a C₁-C₃₀ aliphatic radical, a C₃-C₃₀ cycloaliphatic radical, or a C₃-C₃₀ aromatic radical; with the proviso that when X and Y are both isopropylidene (C(CH₃)₂), R¹ is not a hydrogen atom, a butyl radical, a methoxy radical, a nitro group, or an acetamido group.

3. A composition according to claim 1, wherein said croconine derivative has structure XI; 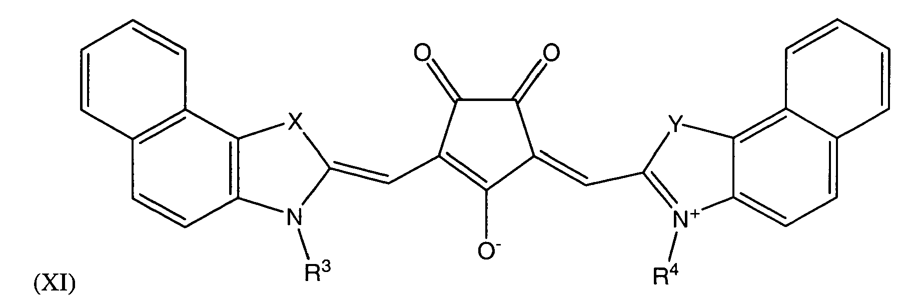 wherein R³ and R⁴ are independently at each occurrence a hydrogen atom, a C₁-C₃₀ aliphatic radical, a C₃-C₃₀ cycloaliphatic radical, a C₃-C₃₀ aromatic radical, a - (CH₂)ₙCOOA group, a -(CH₂)ₙSO₃A group, wherein n is an integer from 1 to 50 and A is a hydrogen atom, a metal cation, a peptide group, or a carbohydrate group; and X and Y are independently an oxygen atom, a sulphur atom, a selenium atom, the group N-R⁵, or the group C-R⁶R⁷wherein R⁵, R⁶, and R⁷ are independently at each occurrence a hydrogen atom, a C₁-C₃₀ aliphatic radical, a C₃-C₃₀ cycloaliphatic radical, or a C₃-C₃₀ aromatic radical; with the proviso that when X and Y are both isopropylidene (C(CH₃)₂), R³ and R⁴ are not hydrogen atoms.

4. A composition comprising at least one croconine derivative having structure I 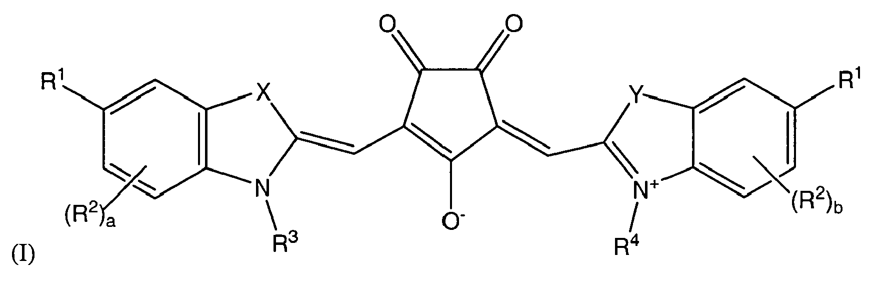 wherein R¹ and R² are independently at each occurrence a hydrogen atom , a halogen atom, a C₁-C₃₀ aliphatic radical, a C₃-C₃₀ cycloaliphatic radical, a C₃-C₃₀ aromatic radical, a hydroxyl group, a carboxy group or a salt thereof, a nitro group, a nitroso group, or a cyano group;
"a" and "b" are independently integers from 0 to 4;
R³ and R⁴ are independently at each occurrence a hydrogen atom, a C₁-C₃₀ aliphatic radical, a C₃-C₃₀ cycloaliphatic radical, a C₃-C₃₀ aromatic radical, a -(CH₂)ₙCOOA group, a -(CH₂)ₙSO₃A group, wherein n is an integer from 1 to 50 and A is a hydrogen atom, a metal cation, a peptide group, or a carbohydrate group;
X and Y are independently an oxygen atom, a sulphur atom, a selenium atom, the group N-R⁵, or the group C-R⁶R⁷wherein R⁵, R⁶, and R⁷ are independently at each occurrence a hydrogen atom, a C₁-C₃₀ aliphatic radical, a C₃-C₃₀ cycloaliphatic radical, or a C₃-C₃₀ aromatic radical;
and further wherein R¹ and an adjacent R² group may together form a cyclic structure and/or any two adjacent R² groups may together form a cyclic structure;
with the proviso that when
X and Y are both isopropylidene (C(CH₃)₂), and
"a" and "b" are both 0, and
R³ and R⁴ are both hydrogen atoms, then
R¹ is not a hydrogen atom, a C₁-C₅ alkyl radical, a C₁-C₅ alkoxy radical, a nitro group, or an acetamido group;
and with the further proviso that structure I does not include croconine derivative having structure II.

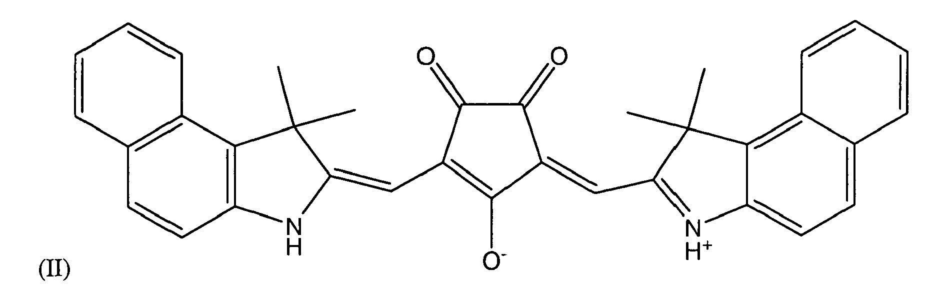

5. A dye-sensitized electrode comprising:
(a) a substrate comprising an electrically conductive surface;
(b) an electron transporting layer disposed on the said electrically conductive surface; and
(c) a composition comprising at least one croconine derivative disposed on the said electrically conductive surface.

6. A dye-sensitized electrode according to claim 5, wherein said composition comprises at least one croconine derivative having structure I; 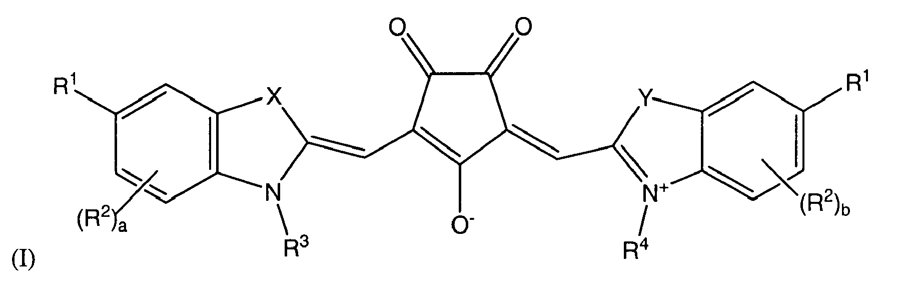 wherein R¹ and R² are independently at each occurrence a hydrogen atom , a halogen atom, a C₁-C₃₀ aliphatic radical, a C₃-C₃₀ cycloaliphatic radical, a C₃-C₃₀ aromatic radical, a hydroxyl group, a carboxy group or a salt thereof, a nitro group, a nitroso group, or a cyano group;
"a" and "b" are independently integers from 0 to 4;
R³ and R⁴ are independently at each occurrence a hydrogen atom, a C₁-C₃₀ aliphatic radical, a C₃-C₃₀ cycloaliphatic radical, a C₃-C₃₀ aromatic radical, a -(CH₂)ₙCOOA group, a -(CH₂)ₙSO₃A group, wherein n is an integer from 1 to 50 and A is a hydrogen atom, a metal cation, a peptide group, or a carbohydrate group;
X and Y are independently an oxygen atom, a sulphur atom, a selenium atom, the group N-R⁵, or the group CR⁶R⁷wherein R⁵, R⁶, and R⁷ are independently at each occurrence a hydrogen atom, a C₁-C₃₀ aliphatic radical, a C₃-C₃₀ cycloaliphatic radical, or a C₃-C₃₀ aromatic radical;
and further wherein R¹ and an adjacent R² group may together form a cyclic structure and/or any two adjacent R² groups may together form a cyclic structure;
with the proviso that when
X and Y are both isopropylidene (C(CH₃)₂), and
"a" and "b" are both 0, and
R³ and R⁴ are both hydrogen atoms, then
R¹ is not a hydrogen atom, a butyl C₁-C₅ alkyl radical, a C₁-C₅ alkoxy radical, a nitro group, or an acetamido group;
and with the further proviso that structure I does not include croconine derivative having structure II.

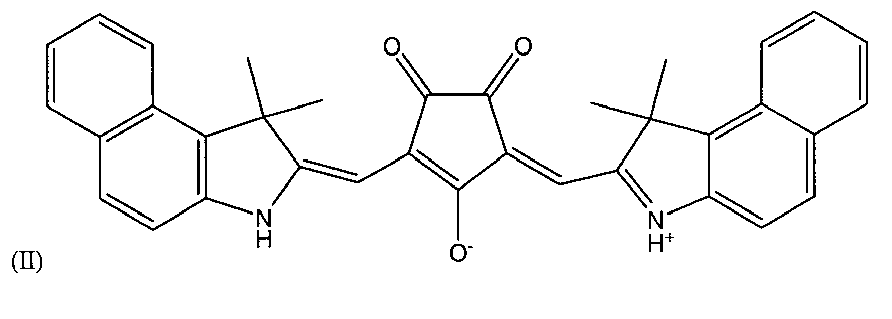

7. A photovoltaic cell comprising:
(a) a dye-sensitized electrode comprising a substrate comprising an electrically conductive surface; an electron transporting layer disposed on the said electrically conductive surface; and a composition comprising at least one croconine derivative disposed on the said electron transporting layer.
(c) a counter electrode; and
(d) a hole transporting layer contacting with said dye-sensitized electrode and said counter electrode.

8. A photovoltaic cell according to claim 7, wherein said composition comprises at least one croconine derivative having structure I; 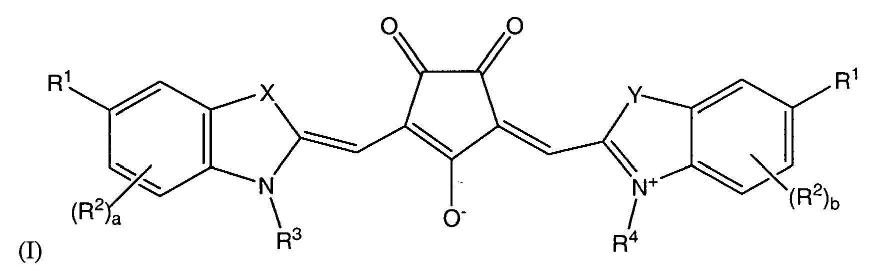 wherein R¹ and R² are independently at each occurrence a hydrogen atom , a halogen atom, a C₁-C₃₀ aliphatic radical, a C₃-C₃₀ cycloaliphatic radical, a C₃-C₃₀ aromatic radical, a hydroxyl group, a carboxy group or a salt thereof, a nitro group, a nitroso group, or a cyano group;
"a" and "b" are independently integers from 0 to 4;
R³ and R⁴ are independently at each occurrence a hydrogen atom, a C₁-C₃₀ aliphatic radical, a C₃-C₃₀ cycloaliphatic radical, a C₃-C₃₀ aromatic radical, a -(CH₂)ₙCOOA group, a -(CH₂)ₙSO₃A group, wherein n is an integer from 1 to 50 and A is a hydrogen atom, a metal cation, a peptide group, or a carbohydrate group;
X and Y are independently an oxygen atom, a sulphur atom, a selenium atom, the group N-R⁵, or the group CR⁶R⁷wherein R⁵, R⁶, and R⁷ are independently at each occurrence a hydrogen atom, a C₁-C₃₀ aliphatic radical, a C₃-C₃₀ cycloaliphatic radical, or a C₃-C₃₀ aromatic radical;
and further wherein R¹ and an adjacent R² group may together form a cyclic structure and/or any two adjacent R² groups may together form a cyclic structure;
with the proviso that when
X and Y are both isopropylidene (C(CH₃)₂), and
"a" and "b" are both 0, and
R³ and R⁴ are both hydrogen atoms, then
R¹ is not a hydrogen atom, a butyl C₁-C₅ alkyl radical, a C₁-C₅ alkoxy radical, a nitro group, or an acetamido group;
and with the further proviso that structure I does not include croconine derivative having structure II

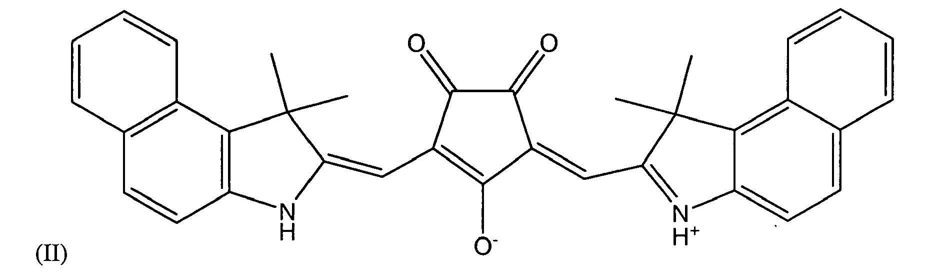

9. A photovoltaic cell according to claim 7 or claim 8, wherein said photovoltaic cell is a photovoltaic power source as a single cell or in tandem with other photovoltaic cells.

10. A photovoltaic cell according to claim 7 or claim 8, wherein a plurality of said photovoltaic cells are arranged in tandem to work as a photovoltaic source.
